# FASCICULE DE BREVET EUROPEEN

(11) **EP 0 689 713 B1**
(45) Date de publication et mention de la délivrance du brevet: **21.10.1998**
(21) Numéro de dépôt: 94909974.1
(22) Date de dépôt: 16.03.1994
(51) Int. Cl.: G11C 11/412

(54) **CELLULE MEMOIRE INSENSIBLE AUX COLLISIONS D'IONS LOURDS**
GEGEN KOLLISIONEN VON SCHWEREN IONEN UNEMPFINDLICHE SPEICHERZELLE
MEMORY CELL INSENSITIVE TO HEAVY ION COLLISIONS

(30) Priorité: 18.03.1993 FR 9303333
(43) Date de publication de la demande: 03.01.1996
(73) Titulaire: CENTRE NATIONAL DE LA RECHERCHE SCIENTIFIQUE (CNRS), 75700 Paris Cedex 07 (FR)
(72) Inventeur: BESSOT, Denis 38, chemin de Pouzon, F-31140 Saint-Loup (FR); VELAZCO, Raoul, F-38100 Grenoble (FR)
(74) Mandataire: de Beaumont, Michel
(86) Numéro de dépôt international: FR9400287
(87) Numéro de publication internationale: WO9422143

(56) Documents cités:
- EP-A- 0 410 885
- US-A- 3 928 773
- US-A- 4 852 060

## Description

La présente invention concerne les cellules mémoire statiques et plus particulièrement des cellules mémoire dont l'état n'est pas modifié par la collision d'un ion lourd sur une zone sensible de la cellule.

Des équipements électroniques peuvent, dans certaines conditions, notamment dans l'espace, être soumis à des bombardements de particules, en particulier des ions lourds. Lorsque la région de drain d'un transistor MOS polarisé d'une manière déterminée est traversée par un ion lourd, le transistor MOS génère une impulsion parasite sur son drain. Un tel phénomène de perturbation, couramment appelé phénomène de "upset", peut entraîner des effets gênants, notamment changer l'état de la cellule mémoire par suite de l'action de l'impulsion parasite sur divers transistors de la cellule.

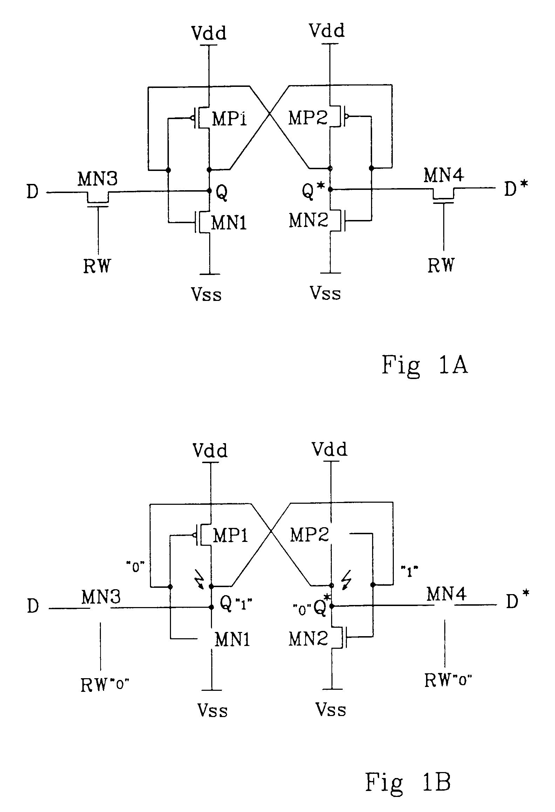

La figure 1A illustre une structure de cellule mémoire classique de type différentiel (c'est une cellule qui stocke une donnée sous forme de deux états complémentaires). Cette oellule sert à réaliser des bascules de tout type, des registres et des mémoires différentielles statiques (SRAM). Une mémoire statique, à l'opposée d'une mémoire dynamique, est une mémoire qui n'a pas besoin d'un signal de rafraîchissement pour conserver son état.

La cellule comprend deux inverseurs connectés tête-bêche. Un premier de ces inverseurs comprend un transistor MOS à canal P MP1 et un transistor MOS à canal N MN1 dont les drains sont reliés ensemble et constituent la sortie Q de l'inverseur. Les sources des transistors MP1 et MN1 sont respectivement reliées à un potentiel haut Vdd et à un potentiel bas Vss. Le deuxième inverseur comprend un transistor MOS à canal P MP2 et un transistor MOS à canal N MN2 connectés selon la même configuration respectivement que les transistors MP1 et MN1. Les drains des transistors MP2 et MN2, reliés ensemble, constituent la sortie Q* de ce deuxième inverseur. Les grilles des transistors MP2 et MN2 (l'entrée du deuxième inverseur) sont reliées à la sortie Q du premier inverseur et les grilles des transistors MP1 et MN1 (entrée du premier inverseur) sont reliées à la sortie Q* du deuxième inverseur.

Un transistor MOS à canal N MN3 relie la sortie Q à une ligne de données D et un transistor MOS à canal N MN4 relie la sortie Q* à une ligne de données D*. Les lignes D et D* véhiculent une donnée différentielle (les états des lignes D et D* sont toujours complémentaires) à lire ou à stocker dans la cellule mémoire. Les grilles des transistors MN3 et MN4 sont commandées par une ligne de lecture/écriture RW.

La figure 1B représente la cellule de la figure lA dans un état initial. On a indiqué par "0" des noeuds dont le potentiel est proche du potentiel bas Vss et par "1" des noeuds dont le potentiel est proche du potentiel haut Vdd. On suppose que la cellule est à un état stable, c'est-à-dire que la ligne de lecture/écriture est à un état inactif, "0". Pour que l'on puisse mieux comprendre le fonctionnement de cette cellule mémoire, un transistor bloqué est laissé en blanc.

L'état initial représenté à la figure 1B est tel que les sorties Q et Q* sont respectivement à "1" et à "0". Les transistors MN1, MP2, MN3 et MN4 sont bloqués, et les transistors MP1 et MN2 sont conducteurs.

Pour lire l'état de cette cellule, la ligne RW est activée, ce qui rend conducteurs les transistors MN3 et MN4 qui transmettent respectivement l'état "1" de la sortie Q sur la ligne D et l'état "0" de la sortie Q* sur la ligne D*.

Pour changer l'état de la cellule, la ligne RW est activée et l'on présente un état "0" sur la ligne D et un état "1" sur la ligne D*. Le "0" présent sur la ligne D force à "0" la sortie Q. L'état "O" de la sortie Q, transmis sur les grilles des transistors MP2 et MN2, bloque le transistor MN2 et rend conducteur le transistor MP2. Ainsi, la sortie Q* passe à "1", ce qui bloque le transistor MP1 et rend conducteur le transistor MN1 qui confirme l'état "0" sur la sortie Q. Un effet symétrique est obtenu par la ligne D* qui force à "1" la sortie Q*. La cellule mémoire se trouve alors dans un nouvel état stable.

On conçoit que les lignes D et D* doivent, lors d'un changement d'état de la cellule, être pilotées avec un courant relativement fort puisque l'on cherche, par exemple, à tirer l'état de la sortie Q vers Vss alors que le transistor MP1 tire cet état vers Vdd et que l'on cherche à tirer l'état de la sortie Q* vers Vdd alors que le transistor MN2 tire cet état vers Vss. Il faut donc prévoir, pour l'écriture dans la cellule mémoire, des amplificateurs de courant (buffers) pour imposer les états des sorties Q et Q* malgré la présence de transistors tendant à imposer des états différents. Un amplificateur de courant peut être disposé entre la ligne D et le transistor MN3 et un autre entre la ligne D* et le transistor MN4.

En fin de compte, la cellule occupe une surface importante de silicium et consomme un courant relativement élevé à chaque changement d'état. L'inconvénient d'occupation de surface est moins grave si l'on constitue une mémoire à l'aide de plusieurs cellules, car on prévoit alors une seule paire d'amplificateurs de courant associés à des lignes D et D* sur lesquelles plusieurs cellules mémoire du type de la figure 1A sont reliées en parallèle. Cet inconvénient est, bien entendu, plus grave si les cellules sont utilisées de façon indépendante, par exemple pour réaliser des bascules ou tout autre circuit à base de bascules (des registres ou des compteurs).

Toutefois, comme on le verra ci-dessous, la cellule de la figure 1A ne peut être utilisée telle quelle dans un milieu soumis à des bombardements d'ions lourds. On appelle ci-après "transistor sensible" un transistor pouvant provoquer un phénomène de perturbation lorsque sa région de drain est traversée par un ion lourd, et on appele "noeud sensible" un noeud relié au drain d'au moins un transistor sensible.

Les transistors sensibles sont, de manière générale, les transistors MOS à canal N à l'état bloqué dont le drain est à un potentiel proche du potentiel d'alimentation haut Vdd ("1") et les transistors à canal P à l'état bloqué dont le drain est à un potentiel proche du potentiel d'alimentation bas Vss ("0"). Si un ion lourd traverse le substrat au voisinage de la région de drain d'un transistor MOS à canal P sensible, une impulsion parasite positive est générée sur le drain, c'est-à-dire que le drain est momentanément tiré vers le potentiel haut Vdd. Dans le cas d'un transistor MOS à canal N sensible, c'est une impulsion négative qui est générée sur le drain, c'est-à-dire que le drain est momentanément tiré vers le potentiel bas Vss.

Dans le cas de la figure 1B, sont sensibles les transistors MN1 et MP2 et, selon l'état des lignes D et D*, les transistors MN3 et MN4. Il en résulte deux noeuds sensibles Q et Q*. Lors d'un phénomène de perturbation sur le noeud Q, c'est-à-dire si une impulsion parasite est générée sur ce noeud, due à un ion lourd traversant une région de drain sensible connectée à ce noeud, un "0" apparaît sur le noeud Q. Ce passage à "0" entraîne la commutation des transistors MN2 et MP2, le passage à "1" du noeud Q* et la confirmation de l'état "O" du noeud Q, c'est-à-dire un changement d'état de la cellule. Un phénomène de perturbation sur le noeud Q* entraîne de même un chargement d'état de la cellule.

On a déjà cherché dans l'art antérieur à résoudre ce problème et à réaliser des cellules mémoire insensibles aux radiations (durcies). Une première approche est de nature technologique et vise à réaliser des transistors intrinsèquement insensibles aux effets des radiations. Pour cela, on réalise les transistors dans des couches minces (quelques micromètres) de silicium formées sur un substrat isolant. Ce sont les technologies couramment désignées par les sigles SOS (Silicon On Sapphire) ou SOI (Silicon On Insulator). Toutefois, ces technologies sont difficiles à mettre en oeuvre et coûteuses.

Une deuxième approche, proposée dans le brevet américain 5 111 429, consiste à utiliser des mémoires redondantes et, par exemple à stocker une donnée dans deux sous-cellules mémoire différentes réalisées, l'une avec des transistors MOS à canal P, et l'autre avec des transistors MOS à canal N. Cette solution engendre une augmentation significative de la surface de silicium et présente le grave inconvénient d'une consommation importante de courant au repos.

Une troisième approche consiste à prévoir une architecture telle qu'une perturbation sur un noeud sensible n'entraîne pas de basculement de cette cellule. Dans le cadre de cette troisième approche, il est proposé (voir IEEE Transactions On Nuclear Science, Volume 35, N° 6, Décembre 1988, pages 1682-1687, "An SEU Hardened CMOS Data Latch") d'utiliser une cellule mémoire du type de celle de la figure lA entourée d'un réseau de transistors MOS à canal P qui a pour rôle de rétablir la donnée modifiée par un phénomène de perturbation. Cette cellule occupe une surface importante de silicium car certains des transistors qui la constituent doivent être choisis grands. Elle présente en outre l'inconvénient, comme la cellule de la figure 1A, de consommer un courant important à la commutation et de nécessiter des amplificateurs de courant.

Un objet de la présente invention est de prévoir une cellule mémoire durcie présentant une très faible probabilité de corruption lors de bombardements d'ions lourds.

Un autre objet de la présente invention est de prévoir une telle cellule qui soit relativement peu coûteuse en surface de silicium.

Un autre objet de l'invention est de prévoir une telle cellule qui consomme peu lors d'une commutation.

Un autre objet de l'invention est de prévoir une telle cellule qui puisse s'insérer dans une architecture de mémoire SRAM classique.

Ces objets sont atteints grâce à une cellule mémoire différentielle pour stocker une donnée différentielle présente sur deux lignes de données lorsqu'une ligne de lecture/écriture est à un état actif, une donnée différentielle stockée dans la cellule étant présente sur deux noeuds de sortie. Selon l'invention, la cellule comprend deux ensembles incluant chacun des premier à troisième transistors reliés en série successivement entre des premier et deuxième potentiels d'alimentation, le premier transistor étant de type différent de celui des deuxième et troisième transistors. Chaque noeud de sortie est le point de connexion entre les premier et deuxième transistors d'un ensemble. L'électrode de commande de l'un des deuxième et troisième transistors de chaque ensemble est reliée au noeud de sortie de l'autre ensemble, et l'électrode de commande de l'autre des deuxième et troisième transistors de chaque ensemble est reliée à l'électrode de commande du premier transistor du même ensemble. Un quatrième transistor, du même type que le premier, associé à chaque ensemble, est relié entre le premier potentiel et l'électrode de commande du premier transistor de l'ensemble, l'électrode de commande de ce quatrième transistor étant reliée à l'électrode de commande du premier transistor de l'autre ensemble. Un cinquième transistor, du même type que le quatrième mais de conductivité inférieure, associé à chaque ensemble, est relié entre l'électrode de commande du premier transistor de l'ensemble et la ligne de lecture/écriture ou le deuxième potentiel, l'électrode de commande de ce cinquième transistor étant reliée au noeud de sortie de l'autre ensemble.

Selon un mode de réalisation de la présente invention, la cellule comprend un sixième transistor associé à chaque ensemble, relié entre une ligne de donnée et le noeud de sortie de l'ensemble, l'électrode de commande du sixième transistor étant reliée à la ligne de lecture/écriture.

Selon un mode de réalisation de la présente invention, le cinquième transistor est relié entre l'électrode de commande du premier transistor de l'ensemble associé et la ligne de lecture/écriture.

Selon un mode de réalisation de la présente invention, les électrodes de commande des premier et deuxième transistors d'un ensemble sont reliées ensemble et l'électrode de commande du troisième transistor de l'ensemble est reliée au noeud de sortie de l'autre ensemble.

Selon un mode de réalisation de la présente invention, le cinquième transistor est relié entre l'électrode de commande du premier transistor de l'ensemble associé et le deuxième potentiel.

Selon un mode de réalisation de la présente invention, les électrodes de commande des premier et troisième transistors d'un ensemble sont reliées ensemble et l'électrode de commande du deuxième transistor de l'ensemble est reliée au noeud de sortie de l'autre ensemble.

Selon un mode de réalisation de la présente invention, la cellule comprend un sixième transistor associé à chaque ensemble, relié entre une ligne de donnée et le point de connexion des deuxième et troisième transistors de l'ensemble, l'électrode de commande du sixième transistor étant reliée à la ligne de lecture/écriture.

Selon un mode de réalisation de la présente invention, la cellule comprend un sixième transistor associé à chaque ensemble, relié entre une ligne de donnée et l'électrode de commande du premier transistor de l'ensemble, l'électrode de commande du sixième transistor étant reliée à la ligne de lecture/écriture.

Selon un mode de réalisation de la présente invention, la cellule comprend un septième transistor associé à chaque ensemble, connecté en diode entre le deuxième potentiel et le troisième transistor de l'ensemble.

Ainsi, la présente invention s'inscrit dans le cadre de la troisième approche susmentionnée, mais présente par rapport aux solutions déjà proposées l'avantage d'une meilleure immunité aux phénomènes de perturbation, d'une plus grande simplicité et d'une plus faible consommation à la commutation.

Ces objets, caractéristiques et avantages de la présente invention seront exposés en détail dans la description suivante de modes de réalisation particuliers faite en relation avec les figures jointes parmi lesquelles :
les figures 1A et 1B, précédemment décrites, représentent une structure de cellule mémoire différentielle statique classique ;
les figures 2A à 2C représentent un mode de réalisation d'une cellule mémoire différentielle durcie selon l'invention dans différents états ;
la figure 3 représente un autre mode de réalisation de cellule mémoire durcie selon l'invention ; et
la figure 4 représente encore un autre mode de réalisation de cellule mémoire durcie selon l'invention.

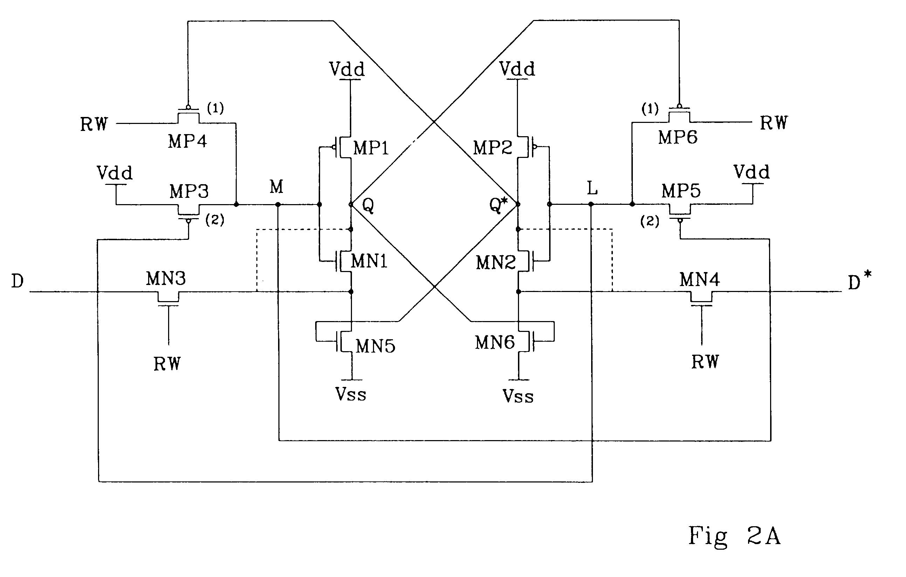

La figure 2A représente des éléments de la figure 1A, désignés par des mêmes références. Les sources des transistors MN1 et MN2, au lieu d'être directement reliées au potentiel bas Vss, comme dans la figure 1A, y sont reliées par l'intermédiaire de transistors MOS à canal N MN5 et MN6 respectivement. Les grilles des transistors MN5 et MN6 sont respectivement reliées au noeud Q* et au noeud Q. Les grilles des transistors MP1 et MN1 sont reliées à un noeud M qui peut être relié au potentiel haut Vdd par un transistor MOS à canal P MP3 ou à la ligne de lecture/écriture RW par un transistor MOS à canal P MP4. Il importe, comme on le verra plus loin, que la transconductance du transistor MP3 soit supérieure à celle du transistor MP4. Le rapport de largeur de canal entre le transistor MP3 et le transistor MP4 est compris entre 1,5 et 3, par exemple 2. Les grilles des transistors MP2 et MN2 sont reliées à un noeud L qui peut lui-même être relié au potentiel haut Vdd ou à la ligne RW respectivement par des transistors MOS à canal P MP5 et MP6 de même rapport de largeur de canal que les transistors MP3 et MP4. Les grilles des transistors MP4 et MP6 sont respectivement reliées au noeud Q* et au noeud Q. Les grilles des transistors MP3 et MP5 sont respectivement reliées au noeud L et au noeud M.

De préférence, les transistors de lecture/écriture MN3 et MN4 sont reliés respectivement entre les transistors MN1 et MN5, et entre les transistors MN2 et MN6, mais ils peuvent aussi être reliés, comme cela est représenté en pointillés, respectivement aux noeuds Q et Q*.

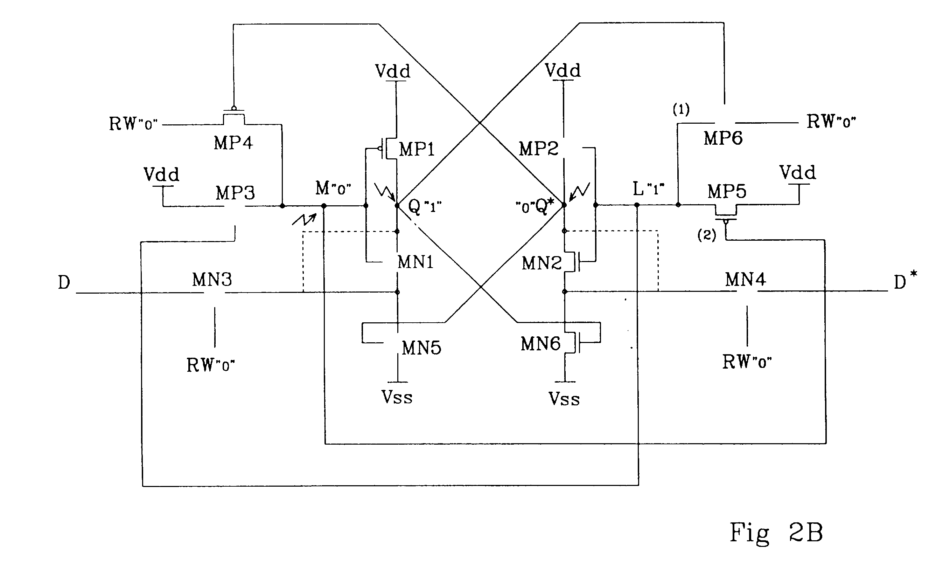

La figure 2B représente la cellule mémoire de la figure 2A dans un état initial dans lequel les noeuds Q et Q* sont supposés respectivement à "1" et à "0". Les états correspondants d'autres noeuds sont aussi indiqués par des "1" et des "0". L'état de la ligne de lecture/écriture RW est supposé inactif, à "0". Dans cet état, les transistors MP1, MN2, MN6, MP4 et MP5 sont conducteurs. Les autres transistors, laissés en blanc, sont bloqués.

Dans son état stable de la figure 2B, la cellule selon l'invention ne consomme aucun courant.

Pour modifier l'état de la cellule, on doit faire passer l'état du noeud Q à "0" et l'état du noeud Q* à "1". Pour cela, on active la ligne RW en présentant un "0" sur la ligne D et l'état complémentaire, "1", sur la ligne D*. L'état "1" de la ligne RW est transféré sur le noeud M par le transistor MP4. Le transistor MPl se bloque et le transistor MN1 devient conducteur. Puisque les transistors MN5 et MP1 sont bloqués, le noeud Q se retrouve seulement relié à la ligne D qui impose son état "0" au noeud Q en consommant seulement un courant de décharge de capacités de drain. L'état "O" du noeud Q bloque le transistor MN6 et rend conducteur le transistor MP6. La ligne RW étant encore à "1", l'état "1" du noeud L n'est pas modifié par le transistor MP6 rendu conducteur. Le noeud Q*, du fait que les transistors MP2 et MN6 sont bloqués, se retrouve seulement relié à la ligne D* qui impose son état "1" au noeud Q* en consommant seulement un courant de charge de capacités de drain. L'état "1" du noeud Q* rend conducteur le transistor MN5 et bloque le transistor MP4. Le transistor MN5 confirme l'état "0" du noeud Q. Le noeud M devient flottant et conserve, par effet capacitif, l'état "1" qui lui a été imposé par la ligne RW.

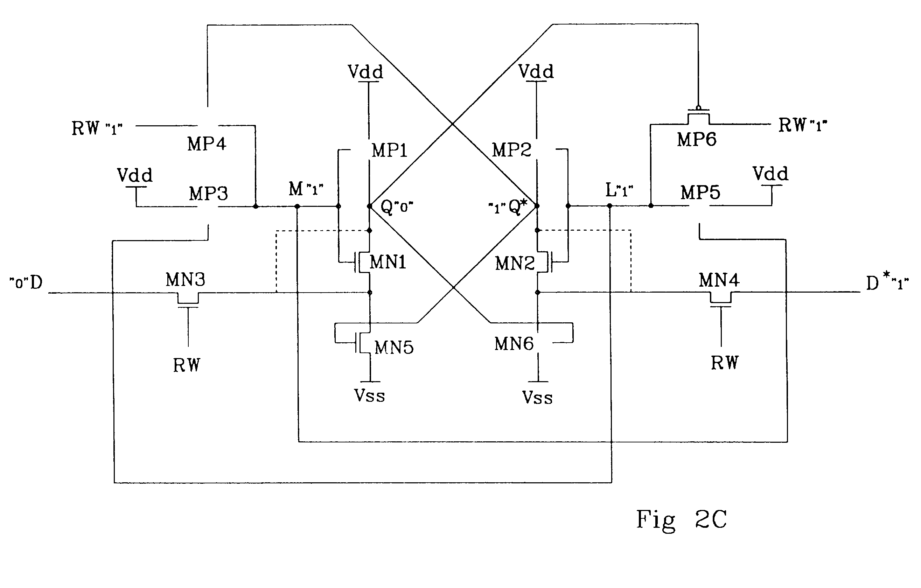

La figure 2C illustre l'état intermédiaire stable atteint par la cellule après les étapes décrites ci-dessus et avant que la ligne RW soit remise à son état de repos "0". Les transistors MN1 à MN5 et le transistor MP6 sont conducteurs alors que les autres transistors, laissés en blanc, sont bloqués. Lorsque la ligne RW repasse à "0", le noeud L passe à "0" et le transistor MP3 devient conducteur en confirmant l'état "1" du noeud M. On se retrouve alors dans l'état stable symétrique de celui de la figure 2B.

Une nouvelle modification de l'état logique de la cellule se produit de manière symétrique de celle qui vient d'être décrite.

Si les lignes D et D* sont reliées aux noeuds Q et Q* selon la liaison en pointillés, la cellule est susceptible, lors de l'écriture, de consommer un courant sur la ligne D pendant le retard de commutation du transistor MP1 de son état passant vers son état bloqué. Par contre, avec la liaison en trait plein, la consommation de courant est négligeable car la ligne D est déconnectée du potentiel Vdd par l'un ou l'autre des transistors MP1 et MN1 qui ne conduisent pas simultanément.

Avec la liaison en trait plein ou avec la liaison en pointillés, un courant est consommé sur la ligne D* avant que le transistor MN6 soit bloqué par le passage à "0" du noeud Q. La commutation du transistor MN6 est toutefois très rapide et on consomme un courant très bref qui n'entrave pas le basculement de la cellule. Avec la liaison en pointillés, le courant consommé serait atténué par le fait qu'il doit traverser deux transistors MN2, MN6 qui ont des caractéristiques résistives.

Dans les deux cas, cette faible consommation à la commutation constitue un avantage notable de la présente invention par rapport aux cellules de l'art antérieur procédant des deuxième et troisième approches susmentionnées.

On va maintenant considérer, en relation avec la figure 2B, le comportement de la cellule mémoire selon l'invention en cas de phénomène de perturbation. A la figure 2B, on a indiqué par des flèches en zig-zag les noeuds sensibles aux phénomènes de perturbation correspondant à l'état stable représenté de la cellule. Les noeuds sensibles sont Q, Q* et M. En effet, le noeud Q est rendu sensible par le drain du transistor MN1, le noeud Q* par le drain du transistor MP2, et le noeud M par le drain du transistor MP3.

Si un phénomème de perturbation survient sur le noeud Q, un "0" apparaît sur les grilles des transistors MN6 et MP6. Le transistor MN6 se bloque et le transistor MP6 devient conducteur. Le noeud Q* devient flottant mais conserve son état "0" par effet capacitif. Les transistors MP6 et MP5 sont conducteurs et tendent chacun à imposer un état différent au noeud L. Comme on l'a précédemment indiqué, la largeur de canal du transistor MP5 est plus grande que celle du transistor MP6 et c'est le transistor MP5 qui continue à imposer l'état "1" (Vdd) au noeud L. Le noeud Q* reste toujours flottant en conservant son état "0". Or, le transistor MP1 restant conducteur, le noeud Q est rapidement rappelé vers son état initial "1". Le transistor MP1 est choisi de taille relativement importante pour rétablir le plus rapidement possible l'état initial du noeud Q. Symétriquement, le transistor MP2 est choisi de la même taille.

Lors d'un phénomène de perturbation sur le noeud Q*, ce dernier passe à "1". Le transistor MN5 devient conducteur et le transistor MP4 se bloque. Le noeud M devient flottant mais conserve son état "0". Le fait que le transistor MN5 soit rendu conducteur n'a aucune influence sur l'état "1" du noeud Q puisque le transistor MN1 reste bloqué. Les transistors MN2 et MN6 restent conducteurs et rappellent le noeud Q* vers sont état initial "0".

Lors d'un phénomène de perturbation sur le noeud M, ce dernier passe à "1". Le transistor MP1 se bloque et le transistor MN1 devient conducteur. Toutefois, comme le transistor MN5 est bloqué, le noeud Q devient flottant et conserve son état "1". En même temps, le transistor MP5 se bloque et rend flottant le noeud L qui conserve son état "1". Ainsi, un phénomène de perturbation sur le noeud M rend flottants les noeuds Q et L sans que cela n'affecte leurs états et par conséquent les états des sorties Q et Q*. Le transistor MP4 rappelle rapidement le noeud M vers son état initial "0".

Lors d'un phénomène de perturbation sur les noeuds Q et Q* simultanément, le transistor MN5 devient conducteur et le transistor MN6 se bloque, mais les états des noeuds M et L ne varient pas, comme on l'a précédemment montré. Le noeud Q* devient flottant mais le noeud Q est vite rappelé vers son état initial "1" par le transistor MP1. Alors, le transistor MN6 devient de nouveau conducteur et rappelle le noeud Q* à son état initial "0".

Des phénomènes de perturbation se produisant simultanément sur les noeuds Q et M ou Q* et M peuvent entraîner une corruption de l'état de la cellule. Toutefois, la probabilité est infime pour que deux ions lourds heurtent simultanément deux drains sensibles correspondants.

La configuration où les lignes D et D* sont reliées aux noeuds Q et Q* (liaison en pointillés) est plus sensible aux phénomènes de perturbation que l'autre configuration (liaison en trait plein). En effet, si l'on considère l'état stable de la figure 2B, le drain du transistor MN3 est sensible et augmente la probabilité de perturbation du noeud Q par la liaison en pointillés.

Lorsque l'état stable de la cellule mémoire de la figure 2A est tel que les noeuds Q et Q* sont respectivement à "0" et à "1", le comportement de la cellule est symétrique devant les phénomènes de perturbation, les rôles des noeuds Q et Q* étant intervertis ainsi que les rôles des noeuds M et L.

Etant donnée la faible consommation de courant sur les lignes D et D* lors d'une écriture dans la cellule mémoire selon l'invention, il est inutile de prévoir des amplificateurs bidirectionnels associés à ces lignes D et D*. Cela représente une économie non négligeable de surface de silicium. Une bascule réalisée avec une cellule selon l'invention est même plus économique en surface qu'une bascule réalisée à l'aide d'une cellule du type de la figure lA qui nécessite des amplificateurs de courant.

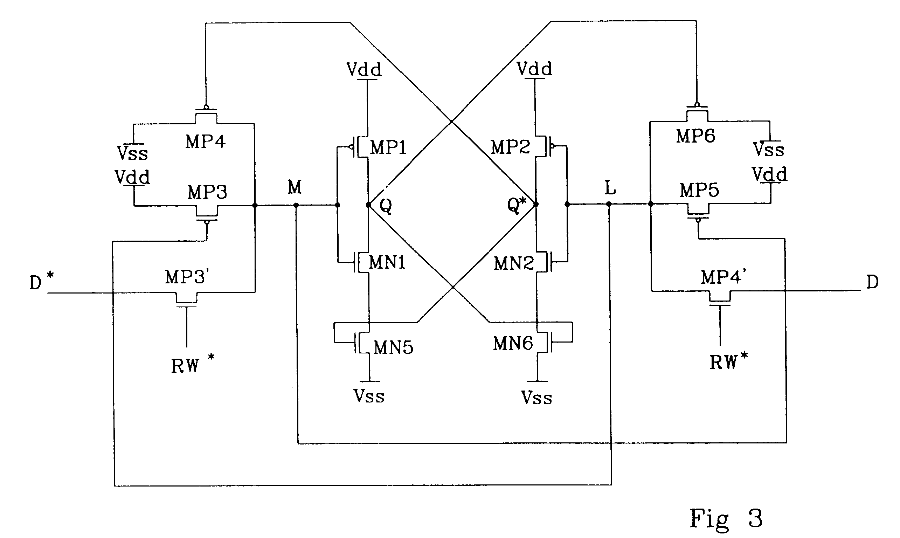

La figure 3 représente un autre mode de réalisation de cellule mémoire selon l'invention. Cette cellule se distingue de la cellule de la figure 2A par le fait que les lignes D et D* sont respectivement reliées aux noeuds L et M au lieu d'être reliées aux noeuds Q et Q*, et par le fait que les transistors MP4 et MP6 sont reliés au potentiel bas Vss au lieu d'être reliés à la ligne d'horloge RW. Selon une variante, les transistors de lecture/écriture MN3 et MN4 de la figure 2A sont remplacés respectivement par les transistors MOS à canal P, MP3' et MP4'. Les grilles des transistors MP3' et MP4' sont commandées par une ligne d'horloge RW* dont l'état actif est "0" au lieu de "1". Le fonctionnement de cette cellule est similaire à celui de la cellule de la figure 2A et la probabilité de corruption par phénomène de perturbation est du même ordre. Toutefois, cette cellule mémoire consomme davantage de courant lors d'une écriture.

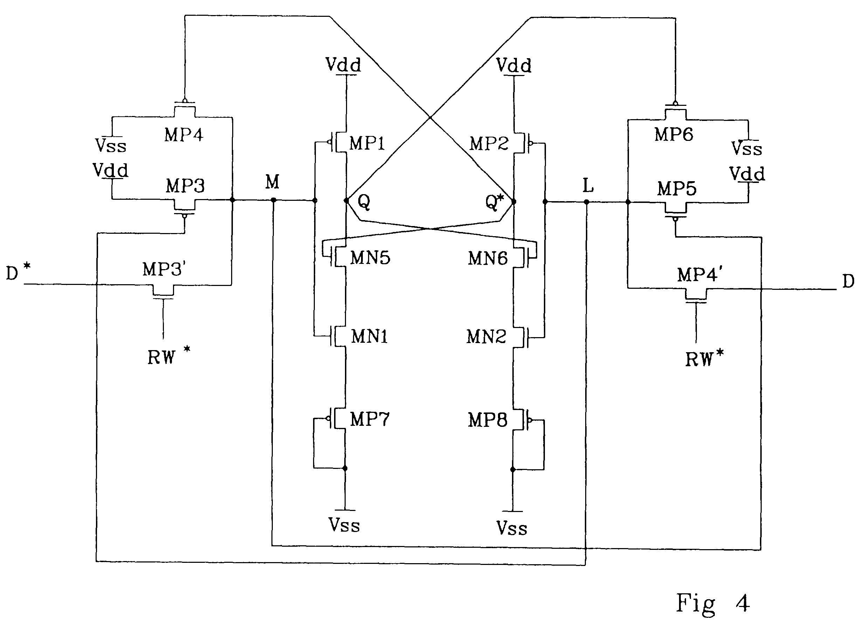

La figure 4 représente un autre mode de réalisation de cellule mémoire selon la présente invention. Par rapport à la cellule mémoire de la figure 3, on a interverti les positions des transistors MN1 et MN5 et les positions des transistors MN2 et MN6. En outre, des transistors MOS à canal P MP7 et MP8, connectés en résistance, sont reliés entre le potentiel bas Vss et respectivement le transistor MN1 et le transistor MN2. Ces transistors MP7 et MP8 permettent de découpler parfaitement les noeuds Q et Q* du potentiel bas Vss, c'est-à-dire que les transistors MN1 et MN2 sont franchement bloqués lorsque, respectivement, le noeud M est à "0" et le noeud L est à "0".

Cette cellule fonctionne de manière similaire et présente sensiblement les mêmes avantages que la cellule de la figure 3.

L'homme du métier pourra combiner les cellules des figures 2A, 3 et 4 pour former d'autres cellules selon l'invention.

De nombreuses variantes et modifications de la présente invention apparaîtront à l'homme du métier, notamment en ce qui concerne le choix des polarités et des tailles des transistors.

## Revendications

1. Cellule mémoire différentielle pour stocker une donnée différentielle présente sur deux lignes de données (D, D*) lorsqu'une ligne de lecture/écriture (RW) est à un état actif, une donnée différentielle stockée dans la cellule étant présente sur deux noeuds de sortie (Q, Q*), caractérisée en ce qu'elle comprend :
- deux ensembles comprenant chacun des premier à troisième transistors (MP1, MN1, MN5 ; MP2, MN2, MN6) reliés en série successivement entre des premier et deuxième potentiels d'alimentation (Vdd, Vss), le premier transistor (MP1, MP2) étant de type différent de celui des deuxième et troisième transistors, et chaque noeud de sortie étant le point de connexion entre les premier et deuxième transistors d'un ensemble ;
- une liaison entre l'électrode de commande de l'un des deuxième et troisième transistors de chaque ensemble et le noeud de sortie de l'autre ensemble, et une liaison entre l'électrode de commande de l'autre des deuxième et troisième transistors de chaque ensemble et l'électrode de commande du premier transistor du même ensemble ;
- un quatrième transistor (MP3, MP5), du même type que le premier, associé à chaque ensemble, relié entre le premier potentiel (Vdd) et l'électrode de commande du premier transistor (MP1, MP2) de l'ensemble, l'électrode de commande de ce quatrième transistor étant reliée à l'électrode de commande du premier transistor de l'autre ensemble ; et
- un cinquième transistor (MP4, MP6), du même type que le quatrième mais de conductivité inférieure, associé à chaque ensemble, relié entre l'électrode de commande du premier transistor de l'ensemble et la ligne de lecture/écriture (RW) ou le deuxième potentiel (Vss), l'électrode de commande de ce cinquième transistor étant reliée au noeud de sortie de l'autre ensemble.

2. Cellule mémoire différentielle selon la revendication 1, caractérisée en ce qu'elle comprend un sixième transistor (MN3, MN4) associé à chaque ensemble, relié entre l'une des lignes de donnée (D, D*) et le noeud de sortie (Q, Q*) de l'ensemble, l'électrode de commande du sixième transistor étant reliée à la ligne de lecture/écriture (RW).

3. Cellule mémoire différentielle selon la revendication 1, caractérisée en ce que le cinquième transistor (MP4, MP6) est relié entre l'électrode de commande du premier transistor de l'ensemble associé et la ligne de lecture/écriture (RW).

4. Cellule mémoire différentielle selon la revendication 1, caractérisée en ce que les électrodes de commande des premier et deuxième transistors (MP1, MN1 ; MP2, MN2) d'un ensemble sont reliées ensemble et en ce que l'électrode de commande du troisième transistor (MN5, MN6) de l'ensemble est reliée au noeud de sortie de l'autre ensemble.

5. Cellule mémoire différentielle selon la revendication 1, caractérisée en ce que le cinquième transistor (MP4, MP6) est relié entre l'électrode de commande du premier transistor de l'ensemble associé et le deuxième potentiel (Vss).

6. Cellule mémoire différentielle selon la revendication 1, caractérisée en ce que les électrodes de commande des premier et troisième transistors (MP1, MN5 ; MP2, MN6) d'un ensemble sont reliées ensemble et en ce que l'électrode de commande du deuxième transistor (MN1, MN2) de l'ensemble est reliée au noeud de sortie de l'autre ensemble.

7. Cellule mémoire différentielle selon la revendication 1, caractérisée en ce qu'elle comprend un sixième transistor (MN3, MN4) associé à chaque ensemble, relié entre l'une des lignes de donnée (D, D*) et le point de connexion des deuxième et troisième transistors de l'ensemble, l'électrode de commande du sixième transistor étant reliée à la ligne de lecture/écriture (RW).

8. Cellule mémoire différentielle selon la revendication 1, caractérisée en ce qu'elle comprend un sixième transistor (MN3, MN4) associé à chaque ensemble, relié entre l'une des lignes de donnée (D, D*) et l'électrode de commande du premier transistor de l'ensemble, l'électrode de commande du sixième transistor étant reliée à la ligne de lecture/écriture (RW).

9. Cellule mémoire différentielle selon la revendication 1, caractérisée en ce qu'elle comprend un septième transistor (MP7, MP8) associé à chaque ensemble, connecté en diode entre le deuxième potentiel (Vss) et le troisième transistor de l'ensemble.

## Patentansprüche

1. Differentialspeicherzelle zum Speichern eines auf zwei Datenleitungen (D, D*) vorliegenden Differential-Datums, wenn eine Lese-/Schreib-Leitung (RW) sich in einem aktiven Zustand befindet, wobei ein in der Zelle gespeichertes Differential-Datum an zwei Ausgangsknotenpunkten (Q, Q*) vorliegt,
dadurch gekennzeichnet, daß die Speicherzelle umfaßt:
- zwei Gruppen, deren jede erste bis dritte Transistoren (MP1, MN1, MN5; MP2, MN2, MN6) umfaßt, die in Reihe miteinander zwischen einem ersten und einem zweiten Speisepotential (Vdd, Vss) liegen, wobei der erste Transistor (MP1, MP2) von verschiedenem Typ als der zweite und der dritte Transistor ist und jeder Ausgangsknotenpunkt jeweils die Verbindungsstelle zwischen den ersten und den zweiten Transistoren einer Gruppe ist;
- eine Verbindung zwischen der Steuerelektrode eines der zweiten oder dritten Transistoren jeder Gruppe und dem Ausgangsknotenpunkt der anderen Gruppe, sowie eine Verbindung zwischen der Steuerelektrode des anderen der zweiten und dritten Transistoren jeder Gruppe mit der Steuerelektrode des ersten Transistors der gleichen Gruppe;
- einen jeweils jeder Gruppe zugeordneten vierten Transistor (MP3, MP5) von gleichem Typ wie der erste Transistor, in Anordnung zwischen dem ersten Potential (Vdd) und der Steuerelektrode des ersten Transistors (MP1, MP2) der Gruppe, wobei die Steuerelektrode dieses vierten Transistors mit der Steuerelektrode des ersten Transistors der anderen Gruppe verbunden ist; sowie
- einen jeweils jeder Gruppe zugeordneten fünften Transistor (MP4, MP6) vom gleichen Typ wie der vierte Transistor, jedoch mit geringerer Leitfähigkeit als dieser, in Anordnung zwischen der Steuerelektrode des ersten Transistors der Gruppe und der Lese-/Schreib-Leitung (RW) oder dem zweiten Potential (Vss), wobei die Steuerelektrode dieses fünften Transistors mit dem Ausgangsknotenpunkt der anderen Gruppe verbunden ist.

2. Differentialspeicherzelle nach Anspruch 1,
dadurch gekennzeichnet, daß sie in Zuordnung zu jeder Gruppe einen sechsten Transistor (MN3, MN4) in Schaltverbindung zwischen einer der Datenleitungen (D, D*) und dem Ausgangsknotenpunkt (Q, Q*) der Gruppe aufweist, wobei die Steuerelektrode des sechsten Transistors mit der Lese-/-Schreib-Leitung (RW) verbunden ist.

3. Differentialspeicherzelle nach Anspruch 1,
dadurch gekennzeichnet, daß der fünfte Transistor (MP4, MP6) jeweils zwischen der Steuerelektrode des ersten Transistors der zugehörigen Gruppe und der Lese-/Schreib-Leitung (RW) angeordnet ist.

4. Differentialspeicherzelle nach Anspruch 1,
dadurch gekennzeichnet, daß die Steuerelektroden der ersten und der zweiten Transistoren (MP1, MN1; MP2, MN2) einer Gruppe miteinander verbunden sind und daß die Steuerelektrode des dritten Transistors (MN5, MN6) der Gruppe mit dem Ausgangsknotenpunkt der anderen Gruppe verbunden ist.

5. Differentialspeicherzelle nach Anspruch 1,
dadurch gekennzeichnet, daß der fünfte Transistor (MP4, MP6) zwischen der Steuerelektrode des ersten Transistors der zugehörigen Gruppe und dem zweiten Potential (Vss) angeordnet ist.

6. Differentialspeicherzelle nach Anspruch 1,
dadurch gekennzeichnet, daß die Steuerelektroden der ersten und dritten Transistoren (MP1, MN5; MP2, MN6) einer Gruppe miteinander verbunden sind und daß die Steuerelektrode des zweiten Transistors (MN1, MN2) der Gruppe mit dem Ausgangsknotenpunkt der anderen Gruppe verbunden ist.

7. Differentialspeicherzelle nach Anspruch 1,
dadurch gekennzeichnet, daß sie in Zuordnung zu jeder Gruppe einen sechsten Transistor (MN3, MN4) in Anordnung zwischen einer der Datenleitungen (D, D*) und der Verbindungsstelle des zweiten und dritten Transistors der Gruppe aufweist, wobei die Steuerelektrode des sechsten Transistors mit der Lese-/Schreib-Leitung (RW) verbunden ist.

8. Differentialspeicherzelle nach Anspruch 1,
dadurch gekennzeichnet, daß sie in Zuordnung zu jeder Gruppe einen sechsten Transistor (MN3, MN4) in Anordnung zwischen einer der Datenleitungen (D, D*) und der Steuerelektrode des ersten Transistors der Gruppe aufweist, wobei die Steuerelektrode des sechsten Transistors mit der Lese-/-Schreib-Leitung (RW) verbunden ist.

9. Differentialspeicherzelle nach Anspruch 1,
dadurch gekennzeichnet, daß sie in Zuordnung zu jeder Gruppe einen siebenten Transistor (MP7, MP8) aufweist, der als Diode zwischen dem zweiten Potential (Vss) und dem dritten Transistor der Gruppe geschaltet ist.

## Claims

1. A differential memory cell for storing a differential data present on two data lines (D, D*) when a read/write line (RW) is in an active state, a differential data stored in the cell being present on two output nodes (Q, Q*), comprising:
- two sets, each including first, second and third transistors (MP1, MN1, MN5; MP2, MN2, MN6) successively serially connected between first and second supply voltages (Vdd, Vss), the type of the first transistor (MP1, MP2) being different from that of the second and third transistors, and each output node corresponding to the junction between the first and second transistors of a set;
- a connection between the control electrode of one of the second and third transistors of each set and the output node of the other set, and a connection between the control electrode of the other of the second and third transistors of each set and the control electrode of the first transistor of the same set;
- a fourth transistor (MP3, MP5), of the same type as the first transistor, associated with each set, connected between the first voltage (Vdd) and the control electrode of the first transistor (MP1, MP2) of the set, the control electrode of said fourth transistor being connected to the control electrode of said first transistor of the other set; and
- a fifth transistor (MP4, MP6), of the same type as the fourth transistor but with a lower conductivity, associated with each set, connected between the control electrode of the first transistor of the set and the read/write line (RW) or the second voltage (VSS), the control electrode of said fifth transistor being connected to the output node of the other set.

2. The differential memory cell of claim 1, comprising a sixth transistor (MN3, MN4) associated with each set, connected between one of the data lines (D, D*) and the output node (Q, Q*) of the set, the control electrode of the sixth transistor being connected to the read/write line (RW).

3. The differential memory cell of claim 1, wherein the fifth transistor (MP4, MP6) is connected between the control electrode of the first transistor of the associated set and the read/write line (RW).

4. The differential memory cell of claim 1, wherein the control electrodes of the first and second transistors (MP1, MN1; MP2, MN2) of a set are connected together and wherein the control electrode of the third transistor (MN5, MN6) of the set is connected to the output node of the other set.

5. The differential memory cell of claim 1, wherein the fifth transistor (MP4, MP6) is connected between the control electrode of the first transistor of the associated set and the second voltage (Vss).

6. The differential memory cell of claim 1, wherein the control electrodes of the first and third transistors (MP1, MN5; MP2, MN6) of a set are connected together and wherein the control electrode of the second transistor (MN1, MN2) of the set is connected to the output node of the other set.

7. The differential memory cell of claim 1, comprising a sixth transistor (MN3, MN4) associated with each set, connected between one of the data lines (D, D*) and the junction of the second and third transistors of the set, the control electrode of the sixth transistor being connected to the read/write line (RW).

8. The differential memory cell of claim 1, comprising a sixth transistor (MN3, MN4) associated with each set, connected between one of the data lines (D, D*) and the control electrode of the first transistor of the set, the control electrode of the sixth transistor being connected to the read/write line (RW).

9. The differential memory cell of claim 1, comprising a seventh transistor (MP7, MP8) associated with each set, connected as a diode between the second voltage (Vss) and the third transistor of the set.
